# EUROPÄISCHE PATENTSCHRIFT

(11) **EP 1 652 389 B1**
(45) Veröffentlichungstag und Bekanntmachung des Hinweises auf die Patenterteilung: **02.01.2008**
(21) Anmeldenummer: 04739645.2
(22) Anmeldetag: 07.06.2004
(51) Int. Cl.: H04Q 1/10, H05K 7/14

(54) **GEHÄUSE ZUR AUFNAHME VON LEITERPLATTEN, DEREN BESTÜCKUNG ZUMINDEST TEILE EINES KOMMUNIKATIONSSYSTEMS BILDET**
HOUSING RECEIVING PRINTED CIRCUIT BOARDS WHOSE COMPONENTS FORM AT LEAST PARTS OF A COMMUNICATION SYSTEM
BOITIER DESTINE A LOGER DES CARTES DE CIRCUITS IMPRIMES, DONT LES COMPOSANTS CONSTITUENT AU MOINS CERTAINES PARTIES D'UN SYSTEME DE COMMUNICATION

(30) Priorität: 08.08.2003 DE 10336610
(43) Veröffentlichungstag der Anmeldung: 03.05.2006
(73) Patentinhaber: SIEMENS AKTIENGESELLSCHAFT, 80333 München (DE)
(72) Erfinder: FÜRSICH, Walter, 44149 Dortmund (DE); HARNISCHMACHER, Friedhelm, 45731 Waltrop (DE); VERDING, Markus, 45279 Essen (DE)
(74) Vertreter: Berg, Peter
(86) Internationale Anmeldenummer: PCT/EP2004/006103
(87) Internationale Veröffentlichungsnummer: WO 2005/025245

(56) Entgegenhaltungen:
- EP-A- 0 964 586
- DE-A- 4 342 739

## Beschreibung

### Technisches Gebiet

Die Erfindung bezieht sich auf ein Gehäuse zur Aufnahme von Leiterplatten, deren Bestückung zumindest Teile eines Kommunikationssystems bildet, mit einer Gehäuseabdeckung und einem von außen zugänglichen Anschlussbereich, wobei eine Hauptleiterplatte zwischen einem Basisgehäuseteil und einem Abdeckteil angebracht ist und in einem Erweiterungsbereich der Hauptleiterplatte Steckvorrichtungen für zumindest eine Erweiterungsleiterplatte vorgesehen sind.

### Stand der Technik

Gehäuse zur Aufnahme von bestückten Leiterplatten sind in verschiedenen Ausführungsformen bekannt. Bei einem Gehäuse, das für Endeinrichtungen eines Kommunikationssystems verwendet wird, besteht häufig die Forderung, dass der konstruktive Grundaufbau des Gehäuses für verschiedene Endgeräte erweiterbar sein muss. Eine Telekommunikationseinrichtung kann beispielsweise im Grundausbau für zwei SO-Amts-Ports und vier analoge Teilnehmeranschlüsse ausgelegt sein. In einer erweiterten Ausbaustufe soll das System für mehrere Systemendgeräte modular erweiterbar sein. Die Erweiterung erfolgt durch Einbau zusätzlicher analoger und/oder digitaler Teilnehmerschnittstellen in Form von Erweiterungskarten, die mittels Steckvorrichtungen mit der Hauptleiterplatte des Kommunikationssystems verbunden werden. Dies bedeutet, dass im Gehäuse ein Einbauraum für diese Erweiterungskarten vorgesehen sein muss, der für autorisierte Personen zugänglich, für den Benutzer aber unzugänglich sein muss. Andererseits muss im Gehäuse ein Anschlussraum vorgesehen sein, der vom Benutzer einfach zu öffnen ist, um seine Teilnehmerendeinrichtungen an das Kommunikationssystem anschließen zu können.

Endeinrichtungen eines Telekommunikationssystems werde in hohen Stückzahlen gefertigt und das Gehäuse muss möglichst einfach und billig herstellbar sein.

Aus die DE 43 42 739 A1 und EP 0 964 586 A2 sind zwei Gehäusen zur Aufnahme von Leiterplatten bekannt, deren Bestückung zumindest Teile eines Kommunikationssystems bildet.

### Darstellung der Erfindung

Der Erfindung liegt die Aufgabe zu Grunde, ein Gehäuse der vorliegenden Art so anzugeben, dass dessen Herstellung billiger ist und so gestaltet ist, dass der Einbauraum für Erweiterungskomponenten ausschließlich autorisierten Personen zugänglich ist, hingegen für den Anschluss von Systemendgeräten der Zugang zu einem Anschlussbereich auf einfache Weise möglich ist.

Diese Aufgabe wird durch die Merkmale des Anspruchs 1 gelöst. Vorteilhafte Ausgestaltungen, Aspekte und Details der Erfindung ergeben sich aus den abhängigen Ansprüchen, der Beschreibung und der beigefügten Zeichnungen.

Erfindungsgemäß ist bei einem Gehäuse der eingangs genannten Art der Erweiterungsbereich durch eine erste Abdeckhaube abgedeckt, welche auf das Basisteil aufgerastet ist, wobei das Lösen der Rastverbindung die Anwendung eines Werkzeuges erfordert. Der Zugang zum Erweiterungsraum ist dadurch auf Personen eingeschränkt, die für Service- oder Wartungsarbeiten autorisiert sind. An einer zum Anschlussbereich angrenzenden Wand der ersten Abdeckhaube sind Durchstecköffnungen vorgesehen. In einem zusammengebauten Zustand korrespondieren diese Durchstecköffnungen mit Steckeinrichtungen auf Ergänzungsleiterplatten, die im Erweiterungsbereich auf die Hauptleiterplatte aufgesteckt sind. Daher ist der Anschluss von Systemendgeräten von außen möglich.

Bevorzugt ist eine Gehäuseausführung, bei der zur Abdeckung des Anschlussbereiches eine zweite Abdeckhaube vorgesehen ist, welche am Basisgehäuseteil mittels einer Schnappverbindung lösbar befestigbar ist. Das Lösen der Schnappverbindung erfordert kein Werkzeug. Die zweite Abdeckhaube kann vom Basisgehäuseteil durch einfache Handhabung abgenommen werden.

Es ist zweckmäßig, wenn das Basisgehäuseteil zur Hauptleiterplatte hinragende Stützteile aufweist. Durch diese Konstruktion ist die Hauptleiterplatte zwischen den Stützteilen und dem abgesenkten Abdeckteil einfach durch Klemmung gehalten.

In einer besonders bevorzugten Ausführungsform sind an der Hauptleiterplatte stirnseitig Steckeinrichtungen vorgesehen, mittels derer eine elektrische Verbindung mit zumindest einer zweiten Erweiterungsleiterplatte herstellbar ist. Diese zweite Erweiterungsleiterplatte, weist ebenfalls Steckeinrichtungen auf, die vom Anschlussbereich her zugänglich sind. Dadurch können die Teilnehmeranschlussschnittstellen auf einfache Weise erweitert werden.

Mit Vorteil sind in einem zum Anschlussbereich liegenden Wandteil der ersten Abdeckhaube Durchstecköffnungen angeordnet, die mit einer Anlaufschräge versehen sind. Durch die Anlaufschräge ist das Aufsetzen der ersten Abdeckhaube leichter und der Abstandsspalt zum Stecker einer Erweiterungsleiterplatte kann enger bemessen werden.

Hinsichtlich der Herstellungskosten ist es besonders günstig, wenn das Abdeckteil, die erste und/oder zweite Abdeckhaube durch Spritzgießen, bevorzugt aus einem Kunststoff, hergestellt ist.

Eine ansprechende Form des Gehäuses ist dadurch gekennzeichnet, dass die erste und die zweite Abdeckhaube in einem konzentrisch zur Längsmittelachse verlaufenden Mittelbereich konvex gewölbt sind.

Hierbei ist bevorzugt, dass in zusammengebautem Zustand die erste Abdeckhaube und die zweite Abdeckhaube mit seitlichen Wandabschnitten des Abdeckteils oberflächenbündig abschließen.

### Kurzdarstellung der Zeichnungen

Die Erfindung wird nun an Hand eines bevorzugten Ausführungsbeispiels unter Bezugnahme auf die beigefügten Zeichnungen näher erläutert. Es zeigen:
- Figur 1: das erfindungsgemäße Gehäuse in einem zusammengebauten Zustand in einer perspektivischen Ansicht.
- Figur 2: das erfindungsgemäße Gehäuse der Figur 1, bei dem die zweite Abdeckhaube entfernt ist und der Anschlussraum einsehbar ist.
- Figur 3: das erfindungsgemäße Gehäuse der Figur 2, bei dem die erste Abdeckhauben in einer abgehobenen Stellung gezeichnet ist.
- Figur 4: das erfindungsgemäße Gehäuse der Figur 1 in einer explodierten Darstellung.
- Figur 5: die erste Abdeckhaube von innen gesehen.

### Ausführung der Erfindung

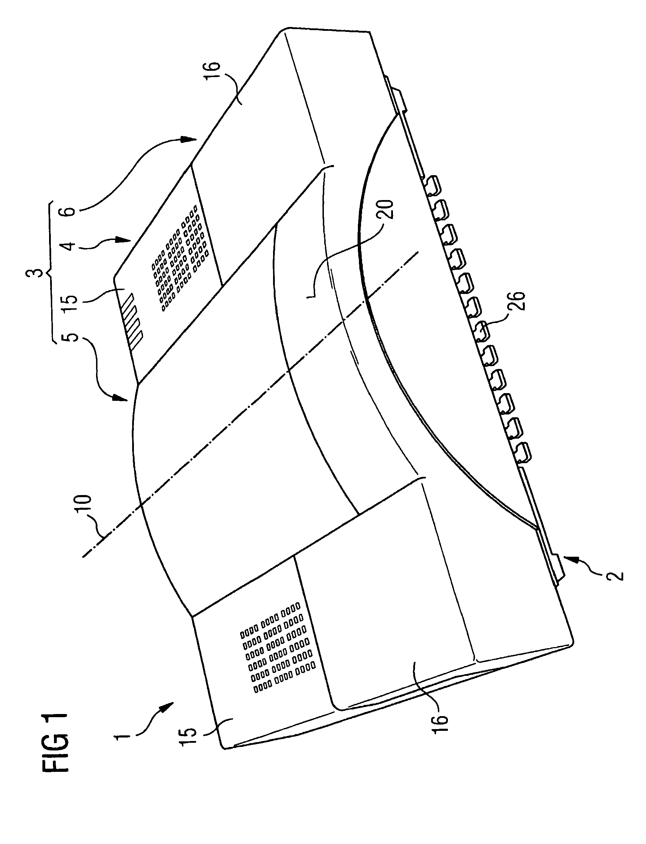

Die Figur 1 zeigt das erfindungsgemäße Gehäuse 1 in einem zusammengebauten Zustand. Das Gehäuse beinhaltet elektronische Komponenten eines Telekommunikationssystems. Es besteht im Wesentlichen aus einem Basisgehäuseteil 2 und einer Gehäuseabdeckung 3. Die Gehäuseabdeckung 3 besteht aus einem Abdeckteil 4, einer ersten Abdeckhaube 5 und einer zweiten Abdeckhaube 6. Die Form des Gehäuses 1 ist in zusammenbauten Zustand im Wesentlichen quaderförmig. Das Abdeckteil 4 und die beiden Abdeckhauben 5 und 6 gruppieren sich symmetrisch zu einer Längsmittelachse 10. Wie aus der perspektivischen Darstellung leicht zu sehen ist, weist das Gehäuse 1 eine konzentrisch zu Längsmittelachse 10 verlaufende konvex geschwungene Frontmittelfläche 20 auf. Seitlich zur Frontmittelfläche 20 schließen sich Wandabschnitte 15 des Abdeckteils 4 und Wandabschnitte 16 der zweiten Abdeckhaube 6 an. Die konvex nach vorne gewölbte Frontmittelfläche 20 geht oberflächenbündig in die Frontflächen der seitlichen Wandabschnitte 15 und 16 über, was dem Gehäuse 1 eine ansprechende äußere Form verleiht.

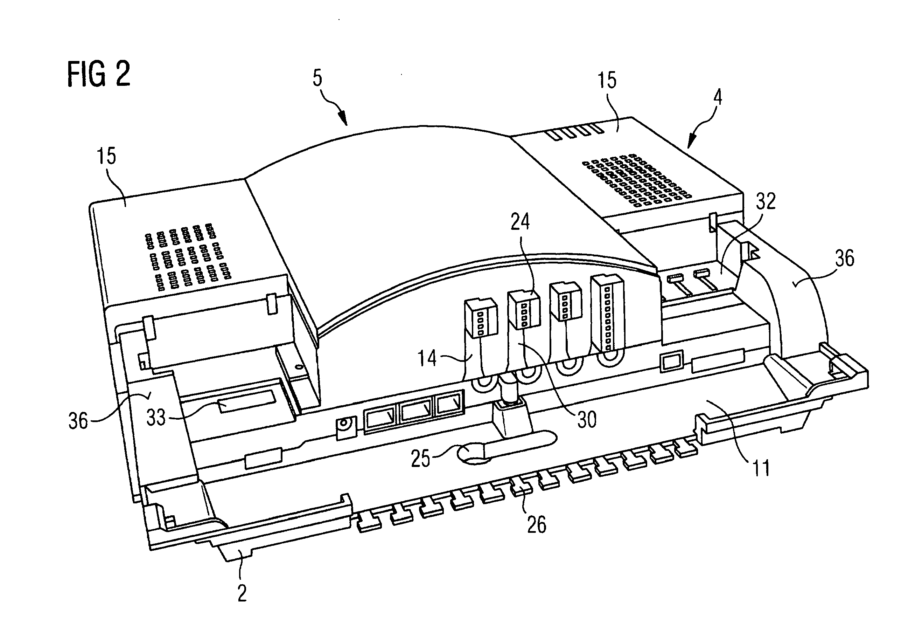

Die Figur 2 zeigt das erfindungsgemäße Gehäuse 1 in einer Darstellung, bei der die zweite Abdeckhaube 6 entfernt ist, wodurch der Anschlussbereich 11 einsehbar ist. Der Anschlussbereich 11 lieg in einer von der Frontseite des Gehäuses zurückspringenden, profilierten Eintiefung. Im Anschlussbereich 11 sind verschiedene Steckeinrichtungen 24, 32, 33 für den elektrischen Anschluss von Systemendgeräten ersichtlich.

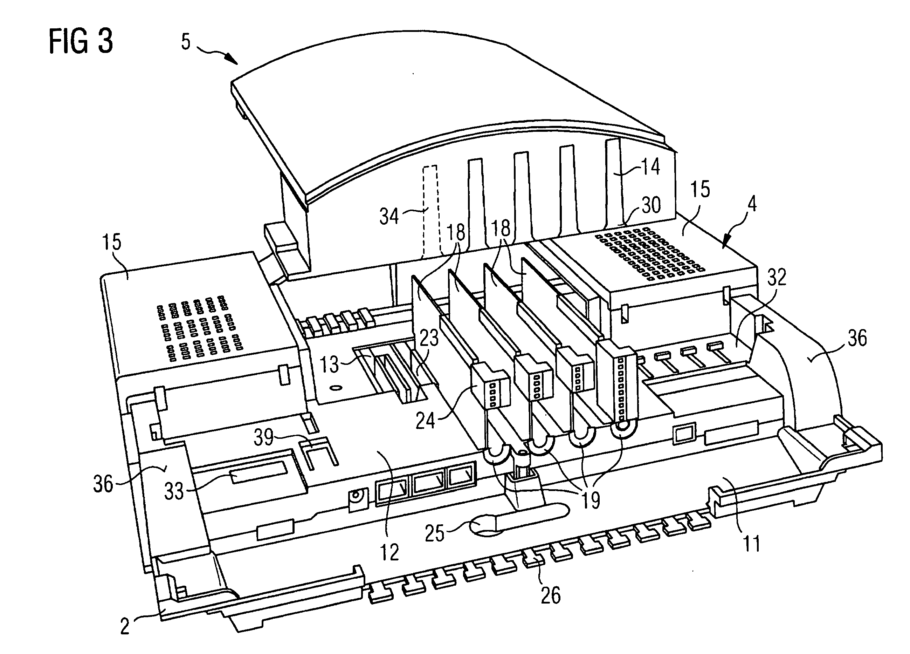

Die Darstellung der Figur 3 unterscheidet sich von der Darstellung in Figur 2 dadurch, dass die erste Abdeckhaube 5 in einer abgehobenen Stellung gezeigt ist. Dadurch wird der Erweiterungsbereich 12 mit den Erweiterungsleiterplatten 18 einsehbar. Die Eintiefung des Abdeckteils 4 setzt sich im Erweiterungsbereich 12 fort und ist durch Stecköffnungen 13 durchbrochen. Die Stecköffnungen 13 machen Steckeinrichtungen 23 sichtbar, die auf der Hauptleiterplatte 8 angebracht sind. In den Steckeinrichtungen 23 stecken Erweiterungsleiterplatten 18; die Zeichnung der Figur 3 zeigt beispielhaft vier eingesteckte Erweiterungsleiterplatten 18. Die Erweiterungsleiterplatten 18 sind an einer bodenseitigen Kante in Führungen 19 des Abdeckteils 4 gehalten. Jede Erweiterungsleiterplatte 18 weist an einer zum Anschlussraum 11 hin liegenden Seite Steckeinrichtungen 24 auf. Die Steckeinrichtungen 24 sind für den Anschluss von benutzerseitigen Endgeräten vorgesehen und vom Anschlussraum 11 her zugänglich.

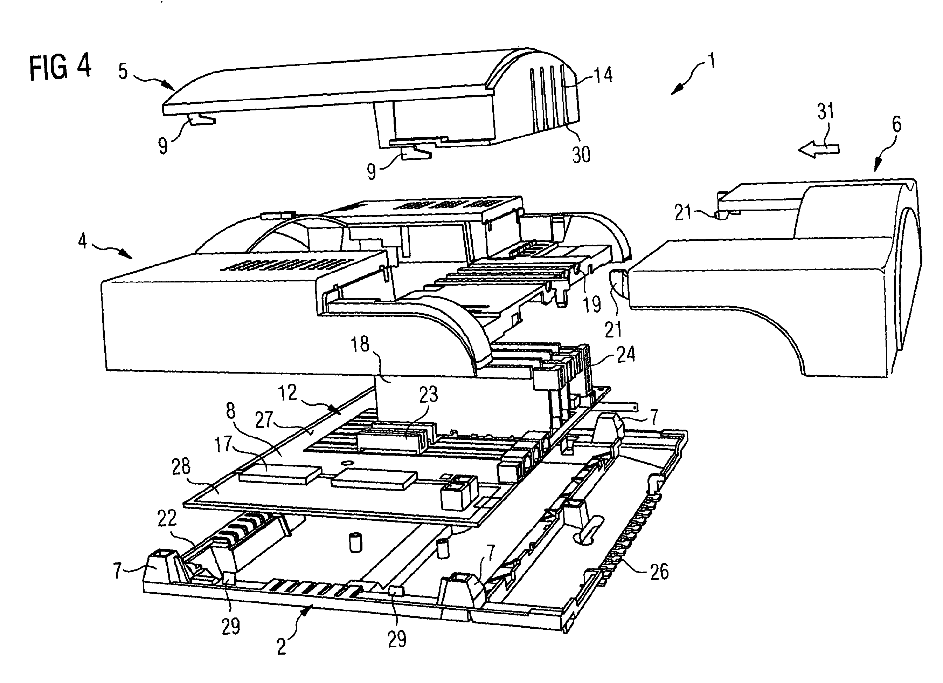

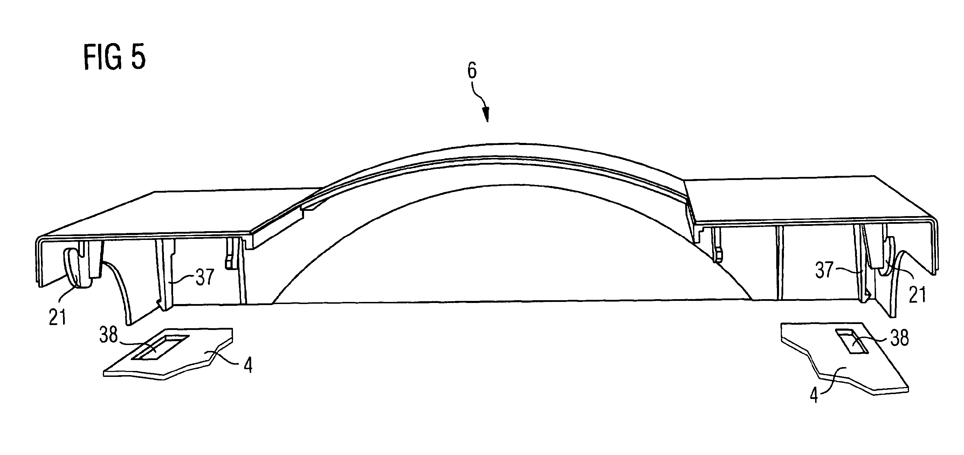

Figur 4 zeigt eine Explosionsdarstellung des erfindungsgemäßen Gehäuses 1. Der Zusammenbau des Kommunikationssystems erfolgt nun so, dass die Hauptleiterplatte 8 auf einem umlaufenden Auflagerand 22 des Basisgehäuseteils 2 aufgelegt und das Abdeckteil 4 darauf aufgesetzt wird (die Führungsteile 7 dienen der Führung der Leiterplatte und des Abdeckteils 4 beim Montieren). Beim Absenken des Abdeckteils 4 werden die Rastfedern 29 des Basisteils 2 ausgelenkt. In einer abgesenkten Stellung des Abdeckteils 4 schnappen die Rastfedern 29 in korrespondierenden Rasthaken des Abdeckteils 4 ein. Im eingeschnappten Zustand wird die Hauptleiterplatte 8 zwischen dem Basisgehäuseteil 2 und dem Abdeckteil 4 durch Klemmung gehalten. In weiterer Folge wird die erste Abdeckhaube 5 aufgesetzt, die Einhängelasche 9 eingehängt und mittels der Verbindung 39 (Fig.3) mit dem Abdeckteil 4 verbunden. Die Rastverbindung 39 ist vom Wartungspersonal des Kommunikationssystems unter Verwendung eines Werkzeuges, z.B. eines Schraubendrehers, erneut lösbar. Für den Benutzer hingegen bleibt der Einbauraum 12 (Fig3) der Erweiterungsleiterplatten 18 unzugänglich. Nach dem Aufbringen der ersten Abdeckhaube 5 erfolgt in einem letzten Schritt des Zusammenbaus die Montage der zweiten Abdeckhaube 6. Hiefür wird die Abdeckhaube 6 auf den Anschlussbereich in Richtung des Pfeils 31 aufgeschoben und mittels Schnapphaken 37 (Fig. 5) mit dem Abdeckteil 4 verbunden. Dies erfolgt in gegenläufiger Richtung und bedarf keines mechanischen Werkzeuges. Die Schwenkriegel 21 helfen beim Einhaken der Haube 6. Durch diese Konstruktion ist die zweite Abdeckhaube 6 manuell einfach abnehmbar und der Anschlussbereich benutzerseitig leicht zugänglich.

Die Rückwand des Basisgehäuseteils 2 weist im Randbereich Einschnitte 26 auf, an denen an- und abgehende Leitungen, beispielsweise durch Kabelbinder, befestigt werden können. Die schlüssellochförmige Ausnehmung 25 dient zur Wandmontage des Gehäuses 1. Zur Abdeckung nicht ausgebauter Steckplätze können Ausbrechteile vorgesehen sein, die je nach Ausbaustufe aus den Öffnungen gebrochen werden. Das gezeigte Ausführungsbeispiel hat vier Einbauplätze für Sub-Module, die jeweils über einen zugänglichen Schnittstellenbereich verfügen. Der fünfte Einbauplatz dient zur Aufnahme eines kürzeren Moduls ohne Schnittstelle nach außen.

Wie in der Explosionsdarstellung der Figur 4 gezeigt, sind an der Hauptleiterplatte 8 stirnseitig Steckeinrichtungen 17 vorgesehen, mittels derer die Hauptleiterplatte 8 mit weiteren Erweiterungsleiterplatten 28 elektrisch verbindbar ist. Diese Erweiterungsleiterplatten 28 werden seitlich auf die Hauptleiterplatte 8 aufgesteckt und verlaufen im Wesentlichen in der Ebene der Hauptleiterplattenfläche 27. Damit kann von einer analogen Teilnehmerschnittstelle 32 in einer erweiterten Ausbaustufe zu einer digitalen Teilnehmerschnittstelle 33 (Fig.2) ausgebaut werden.

Die Fig. 5 zeigt die zweite Abdeckhaube 6 in Blickrichtung vom Anschlussraum her gesehen. Beim Aufsetzen der Abdeckhaube 6 werden die Schwenkriegel 21 in korrespondierende Ausnehmungen der ersten Abdeckhaube 5 eingeführt. Durch Absenken der Abdeckhaube 6 schnappen die Schnapphaken 37 in korrespondierende Ausnehmungen 38 des Abdeckteils 4 ein. Das Lösen dieser Schnappverbindung erfolgt von außen durch Kraftbeaufschlagung der Seitenwände der zweiten Abdeckhaube 6 und bedarf keines Werkzeuges.

Wie aus obigen Ausführungen hervorgeht, besteht das erfindungsgemäße Gehäuse im Wesentlichen aus vier Teilen, die über Rast- bzw. Schnappverbindung zu einer Konstruktion zusammengefügt werden. Der Zusammenbau ist einfach und in vergleichsweise kurzer Zeit möglich. Aufwendige Verbindungsmittel, wie beispielsweise Schrauben, entfallen. Hinsichtlich der Herstellungskosten ist eine Ausführung des Gehäuses aus Kunststoff sehr günstig. Sämtliche Teile der Gehäuseabdeckung 3, wie auch das Basisgehäuseteil lassen sich durch Spritzgießen kostengünstig herstellen.

Selbstverständlich ist die Erfindung nicht auf die Anwendung in einem Telekommunikationssystem eingeschränkt, sondern bei ähnlichen Aufgabenstellungen auch in anderen Gebieten der Elektrotechnik einsetzbar.

### Zusammenstellung verwendeter Bezugszeichen

- 1: Gehäuse
- 2: Basisgehäuseteil
- 3: Gehäuseabdeckung
- 4: Abdeckteil
- 5: erste Abdeckhaube
- 6: zweite Abdeckhaube
- 7: Führungsteile
- 8: Hauptleiterplatte
- 9: Einhängelasche
- 10: Längsmittelachse
- 11: Anschlussraum
- 12: Erweiterungsbereich
- 13: erste Stecköffnung in 4
- 14: zweite Stecköffnungen und in 5
- 15: seitlicher, frontseitig der Wandabschnitten von 4
- 16: seitlicher, frontseitig der Wandabschnitt v6
- 17: stirnseitige Steckeinrichtung
- 18: Erweiterungsleiterplatten (Teilnehmer)
- 19: Führungen für 18
- 20: Konvex geschwungene Frontmittelfläche
- 21: Schwenkriegel
- 22: Auflagekante
- 23: erste Steckeinrichtung
- 24: zweite Steckeinrichtung
- 25: Ausnehmung, schlüssellochförmige
- 26: Einschnitte
- 27: Hauptleiterplattenfläche
- 28: Erweiterungsleiterplatte (digital)
- 29: Rastfeder an 2
- 30: Anlaufschräge
- 31: Pfeil
- 32: analoge Teilnehmerendgeräteanschluss
- 33: digitaler Teilnehmerendgeräteanschluss
- 36: Anlaufflächen
- 37: Schnapphaken von 6
- 38: Ausnehmung in 4
- 39: Rastverbindung zwischen 4 und 5

## Patentansprüche

1. Gehäuse zur Aufnahme von Leiterplatten, deren Bestückung zumindest Teile eines Kommunikationssystems bildet, mit einer Gehäuseabdeckung (3) und einem von außen zugänglichen Anschlussbereich (11), wobei eine Hauptleiterplatte (8) zwischen einem Basisgehäuseteil (2) und einem Abdeckteil (4) angebracht ist und in einem Erweiterungsbereich (12) der Hauptleiterplatte (8) Steckeinrichtungen (23) für zumindest eine Erweiterungsleiterplatte (18) vorgesehen sind, **dadurch gekennzeichnet, dass** zur Abdeckung des Erweiterungsbereiches (12) eine erste Abdeckhaube (5) vorgesehen ist, welche zum Anschlussbereich (11) hin liegende Durchstecköffnungen (14) aufweist, die in einem zusammengebauten Zustand mit Steckeinrichtungen (24) auf der zumindest einen Erweiterungsleiterplatte (18) korrespondieren, wobei die erste Abdeckhaube (5) auf dem Abdeckteil (4) mittels einer Rastverbindung (39) aufrastbar ist und die Rastverbindung (39) nur unter Verwendung eines Werkzeuges erneut lösbar ist.

2. Gehäuse nach Anspruch 1, **dadurch gekennzeichnet, dass** zur Abdeckung des Anschlussbereiches (11) eine zweite Abdeckhaube (6) vorgesehen ist, welche auf das Abdeckteil (4) mittels einer Schnappverbindung (37, 38) lösbar befestigbar ist.

3. Gehäuse nach Anspruch 1 oder 2, **dadurch gekennzeichnet, dass** das Basisgehäuseteil (2) zur Hauptleiterplatte (8) hinragende Führungsteile (7) aufweist und die Hauptleiterplatte (8) zwischen einer Auflagekante (22) des Basisgehäuseteils (2) und dem Abdeckteil (4) durch Klemmung gehalten ist.

4. Gehäuse nach einem der vorstehenden Ansprüche, **dadurch gekennzeichnet, dass** an der Hauptleiterplatte (8) stirnseitig Steckeinrichtungen (17) vorgesehen sind, mittels derer eine elektrische Verbindung mit zumindest einer zweiten Erweiterungsplatte (28) herstellbar ist.

5. Gehäuse nach einem der vorstehenden Ansprüche, **dadurch gekennzeichnet, dass** die Durchstecköffnungen (14) an einem zum Anschlussbereich liegenden Wandteil der ersten Abdeckhaube (5) angeordnet sind.

6. Gehäuse nach einem der vorstehenden Ansprüche, **dadurch gekennzeichnet, dass** die Durchstecköffnungen (14) durch rechteckförmige Ausrisse in dem zum Anschlussbereich liegenden Wandteil gebildet sind und mit einer Anlaufschläge (30) versehen sind.

7. Gehäuse nach einem der vorstehenden Ansprüche, **dadurch gekennzeichnet, dass** das Abdeckteil (4), die erste und / oder zweite Abdeckhaube (5,6) durch Spritzgießen hergestellt ist.

8. Gehäuse nach einem der vorstehenden Ansprüche, **dadurch gekennzeichnet, dass** das Abdeckteil (4), die erste und/oder zweite Abdeckhaube (4,5) jeweils einstückig aus polymeren Werkstoff hergestellt ist.

9. Gehäuse nach einem der vorstehenden Ansprüche, **dadurch kennzeichnet, dass** die erste Abdeckhaube (5) und die zweiten Abdeckhaube (6) in einem konzentrisch zur Längsmittelachse (10) verlaufenden Mittelbereich konvex gewölbt ist.

10. Gehäuse nach einem der vorstehenden Ansprüche, **dadurch gekennzeichnet, dass** in zusammengebautem Zustand die erste Abdeckhaube (5) und die zweite Abdeckhaube (6) mit seitlichen Wandabschnitten (15,16) des Abdeckteils (4) oberflächenbündig abschließen.

11. Gehäuse nach einem der vorstehenden Ansprüche, **dadurch gekennzeichnet, dass** am Basisgehäuseteil (2) schlüssellochförmige Ausnehmungen (25) zur Wandmontage vorgesehen sind.

12. Gehäuse nach einem der vorstehenden Ansprüche, **dadurch gekennzeichnet, dass** am Abdeckteil (4) in seitlichen Begrenzungen des Anschlussbereichs (11) kufenförmige Anlaufflächen (36) ausgebildet sind.

## Claims

1. Housing for receiving printed circuit boards, whose components form at least part of a communication system, with a housing cover (3) and a connection area (11) accessible from outside, with a main printed circuit board (8) being arranged between a base housing part (2) and a cover part (4) and in an extension area (12) of the main printed circuit board (8) plug-in devices (23) being provided for at least one extension printed circuit board (18), **characterized in that**, to cover the extension area (12) a first hood (5) is provided which features push-through openings (14) towards the connection area (11), which in an assembled state correspond with plug-in devices (24) on the at least one extension circuit board (18), with the first hood (5) being able to be latched onto the cover part (4) by means of a lock connection (39) and the lock connection (39) only being able to be released again if a tool is used to do so.

2. Housing in accordance with claim 1, **characterized in that**, to cover the connection area (11) a second hood (6) is provided, which can be connected to the cover part (4) by means of releasable snap-in connection (37, 38).

3. Housing in accordance with claim 1 or 2, **characterized in that** the base housing part (2) features guides (7) extending through the main printed circuit board (8) and the main printed circuit board (8) is held between a support edge (22) of the base housing part (2) and the cover part (4) by clamping.

4. Housing in accordance within one of the previous claims, **characterized in that** plug-in devices (17) are provided on the face of the main printed circuit board (8), by means of which an electrical connection with at least a second extension printed circuit board (28) is established.

5. Housing in accordance with one of the previous claims, **characterized in that** the push-through openings (14) are arranged on the part of the wall of the first hood (5) facing towards the connection area.

6. Housing in accordance with one of the previous claims, **characterized in that** the push-through openings (14) are provided by rectangular break outs in the part of the wall towards the connection area and are provided with a starting bevel (30).

7. Housing in accordance with one of the previous claims, **characterized in that** the cover part (4), the first and/or second hood (5, 6) is manufactured by injection moulding.

8. Housing in accordance with one of the previous claims, **characterized in that** the cover part (4), the first and/or second hood (5, 6) is manufactured in one piece from polymer plastic in each case.

9. Housing in accordance with one of the previous claims, **characterized in that** the first hood (5) and the second hood (6) are curved in a convex shape in a central area running concentrically to the centre longitudinal axis (10).

10. Housing in accordance with one of the previous claims, **characterized in that**, in the assembled state the first hood (5) and the second hood (6) adjoin side wall sections (15, 16) of the cover part (4) to form a continuous surface.

11. Housing in accordance with one of the previous claims, **characterized in that** keyhole-shaped cutouts (25) for wall mounting are provided on the base housing part (2).

12. Housing in accordance with one of the previous claims, **characterized in that**, on the cover part (4) in side restrictions of the connection area (11) runner-shaped starting surfaces (36) are embodied.

## Revendications

1. Boîtier pour loger des cartes de circuits imprimés dont les composants constituent au moins des parties d'un système de communication, avec un couvercle de boîtier (3) et avec une zone de raccordement (11) accessible de l'extérieur, une carte de circuits imprimés principale (8) étant placée entre une partie de boîtier de base (2) et une partie de recouvrement (4) et des dispositifs connecteurs (23) destinés à au moins une carte de circuits imprimés d'extension (18) étant prévus dans une zone d'extension (12) de la carte de circuits imprimés principale (8), **caractérisé par le fait que**, pour couvrir la zone d'extension (12), il est prévu un premier capot (5) qui comporte des ouvertures de connexion traversante (14) qui sont disposées en direction de la zone de raccordement (11) et qui correspondent à l'état monté à des dispositifs connecteurs (24) sur la ou les cartes de circuits imprimés d'extension (18), le premier capot (5) étant enclenchable sur la partie de recouvrement (4) au moyen d'un assemblage à crans (39) et l'assemblage à crans (39) ne pouvant être à nouveau défait qu'en utilisant un outil.

2. Boîtier selon la revendication 1, **caractérisé par le fait que**, pour recouvrir la zone de raccordement (11), il est prévu un deuxième capot (6) qui peut être fixé, amovible, sur la partie de recouvrement (4) au moyen d'un assemblage à enclenchement (37, 38).

3. Boîtier selon la revendication 1 ou 2, **caractérisé par le fait que** la partie de boîtier de base (2) comporte des pièces de guidage (7) dépassant vers la carte de circuits imprimés principale (8) et la carte de circuits imprimés principale (8) étant maintenue par serrage entre un bord d'appui (22) de la partie de boîtier de base (2) et la partie de recouvrement (4).

4. Boîtier selon l'une des revendications précédentes, **caractérisé par le fait qu'**il est prévu sur la carte de circuits imprimés principale (8), du côté frontal, des dispositifs connecteurs (17) au moyen desquels une liaison électrique peut être établie avec au moins une deuxième carte d'extension (28).

5. Boîtier selon l'une des revendications précédentes, **caractérisé par le fait que** les ouvertures de connexion traversante (14) sont disposées sur une partie de paroi, située du côté de la zone de raccordement, du premier capot (5).

6. Boîtier selon l'une des revendications précédentes, **caractérisé par le fait que** les ouvertures de connexion traversante (14) sont formées par des entailles rectangulaires dans la partie de paroi située du côté de la zone de raccordement et sont munies d'un biseau de démarrage (30).

7. Boîtier selon l'une des revendications précédentes, **caractérisé par le fait que** la partie de recouvrement (4), le premier et/ou le deuxième capot (5, 6) sont fabriqués par moulage par injection.

8. Boîtier selon l'une des revendications précédentes, **caractérisé par le fait que** la partie de recouvrement (4), le premier et/ou le deuxième capot (4, 5) sont fabriqués chacun d'un seul tenant en un matériau polymère.

9. Boîtier selon l'une des revendications précédentes, **caractérisé par le fait que** le premier capot (5) et le deuxième capot (6) sont cintrés, convexes, dans une zone médiane concentrique par rapport à l'axe médian longitudinal (10).

10. Boîtier selon l'une des revendications précédentes, **caractérisé par le fait que**, à l'état monté, le premier capot (5) et le deuxième capot (6) sont fermés par des parties de paroi latérales (15, 16) de la partie de recouvrement (4) de manière à ce que les surfaces affleurent.

11. Boîtier selon l'une des revendications précédentes, **caractérisé par le fait qu'**il est prévu sur la partie de boîtier de base (2) des évidements en forme de trous de serrure (25) pour le montage de paroi.

12. Boîtier selon l'une des revendications précédentes, **caractérisé par le fait qu'**il est prévu sur la partie de recouvrement (4) des surfaces de démarrage (36) en forme de spatule au niveau des limites latérales de la zone de raccordement (11).
